# EUROPÄISCHE PATENTSCHRIFT

(11) **EP 3 731 370 B1**
(45) Veröffentlichungstag und Bekanntmachung des Hinweises auf die Patenterteilung: **17.08.2022**
(21) Anmeldenummer: 20165067.8
(22) Anmeldetag: 24.03.2020
(51) Int. Cl.: H02J 13/00, H02J 3/00, G01R 22/06

(54) **VERFAHREN UND SYSTEM ZUR ERSTELLUNG EINER ZUORDNUNG ZWISCHEN EINEM VERBRAUCHSMENGENZÄHLER UND EINER STEUEREINRICHTUNG**
METHOD AND SYSTEM FOR ESTABLISHING AN ALLOCATION BETWEEN A CONSUMPTION METER AND A CONTROL DEVICE
PROCÉDÉ ET SYSTÈME DE GÉNÉRATION D'UNE ATTRIBUTION ENTRE UN COMPTEUR DE CONSOMMATION ET UN DISPOSITIF DE COMMANDE

(30) Priorität: 23.04.2019 DE 102019110447
(43) Veröffentlichungstag der Anmeldung: 28.10.2020
(73) Patentinhaber: Innogy SE, 45128 Essen (DE)
(72) Erfinder: Gaul, Armin, 59379 Selm (DE); Hammerschmidt, Torsten, 44267 Dortmund (DE)
(74) Vertreter: Cohausz & Florack

(56) Entgegenhaltungen:
- WO-A2-2014/152458
- GB-A- 2 519 632

## Beschreibung

Der Gegensand betrifft ein Verfahren und ein System zur Erstellung einer Zuordnung zwischen einem Verbrauchsmengenzähler und einer Steuereinrichtung.

Sowohl im gewerblichen Bereich als auch im häuslichen Umfeld werden zunehmend Energiemanagementsysteme eingesetzt, mit denen sich Teilnehmer, welche am elektrischen Verteilnetz betrieben werden, steuern lassen. Solche Energiemanagementsystem (EMS) sind dazu eingerichtet, Schaltbefehle an die Teilnehmer zu übermitteln, um somit eine Fernsteuerbarkeit der Teilnehmer zu ermöglichen. Im häuslichen Einsatz werden EMS auch Home-Energy-Management Systeme (HEMS) genannt.

Ein Teilnehmer kann eine elektrische Last und/oder ein elektrischer Verbraucher sein. Dies kann beispielsweise eine fernsteuerbare Funksteckdose sein, die von einer zentralen Steuereinrichtung im Haushalt angesteuert wird.

Steuereinrichtungen sind beispielsweise Smart-Home-Controller, Router mit Steuerungsfunktionen, Energiemanager (z.B. Kiwi Grid) oder dergleichen. Steuereinrichtungen können beispielsweise auch Steuerungen von weißer Ware (z.B. Spülmaschine, Wäschetrockner und Waschmaschine), Heizungssteuerungen oder auch Ladesteuereinrichtungen für Elektrofahrzeuge sein. Steuereinrichtungen können auch Umrichter, insbesondere Wechsel- und Gleichrichter an Erzeugungsanlagen, wie beispielsweise PV-Anlagen und Windkraftanlagen oder Energiespeichern, wie beispielsweise Batterien, sein.

Neben der Erweiterung der Funktionalität zur Steuerung von Teilnehmern wird darüber hinaus der Ausbau von Messsystemen an elektrischen Verteilnetzen vorangetrieben. Messsysteme sind beispielsweise Smart-Meter oder intelligente Messsysteme, die beispielsweise mittels Verbrauchsmengenzähler und Gateway (z.B. Smart-Meter-Gateway) oder andere Kommunikationsmöglichkeiten mit weiteren Teilnehmern, beispielsweise einer Zentrale oder auch der Steuereinrichtung kommunizieren können. Neben geeichten Messsystemen können in gleicher Weise auch ungeeichte Messsysteme (z. B. Energiekostenmessgeräte, ...) eingesetzt werden, sofern diese eine Kommunikationsmöglichkeit besitzen. Auch eine Kombination aus geeichten und ungeeichten Messsystemen ist möglich.

Mit Hilfe solcher Messsysteme ist es möglich, nicht nur die von einem Teilnehmer bezogenen oder zur Verfügung gestellten Energiemengen zu messen, sondern auch Energieflussrichtungen sowie zeitliche Auflösungen der jeweiligen Energieflüsse.

Um die vorhandenen Steuereinrichtungen nutzen zu können, um definiert Einfluss auf Netzlasten innerhalb von Verteilnetzen nehmen zu können, ist eine informationstechnische Zuordnung zwischen den Steuereinrichtungen und den Messsystemen unerlässlich.

Derzeit erfolgt die informationstechnische Verknüpfung von energiemesstechnischen Einheiten mit den vor Ort vorhandenen flexiblen Anlagen des Haushalts über Kabel oder Funkbasis. Die Verknüpfung wird jedoch manuell durchgeführt, beispielsweise in einem sogenannten "Pairing-Prozess". Dieser Vorgang ist aufwändig und zeitintensiv. Ferner ist die einmal festgelegte Zuordnung statisch.

Dokumente GB 2 519 632 A und WO 2014/152458 A2 zeigen entsprechende herkömmliche Systeme.

Aus diesem Grunde lag dem Gegenstand die Aufgabe zugrunde, eine Zuordnung mittels einer Feststellung einer Beeinflussung zwischen einer Steuereinrichtung und einem an einem Versorgungsnetz betriebenen Messsystem zu vereinfachen und insbesondere zu automatisieren.

Diese Aufgabe wird durch ein Verfahren nach Anspruch 1 sowie ein System nach Anspruch 15 gelöst.

Die gegenständliche Lösung ermöglicht es, automatisch festzustellen, durch welche Steuereinrichtung, an einem jeweiligen Verbrauchsmengenzähler Energieflüsse beeinflusst werden können. An einem Verbrauchsmengenzähler werden Teilnehmer angeschlossen. Die Teilnehmer sind über den Verbrauchsmengenzähler in einem Versorgungsnetz betrieben.

Teilnehmer im Sinne des Gegenstandes können Lasten, Erzeuger oder Speicher sein. Der Gegenstand lässt sich insbesondere auf elektrische Systeme anwenden, ist jedoch auch beispielsweise im Bereich der Gasverteilung und/oder Wasserverteilung einsetzbar. Nachfolgend wird das Verfahren für elektrische Systeme beschrieben, das Verfahren ist jedoch auch, wie oben beschrieben, auf andere Systeme anwendbar.

Eine elektrische Last kann ein elektrischer Verbraucher sein. Ein elektrischer Erzeuger kann beispielsweise eine Erzeugungsanlage, z.B. Fotovoltaik Anlage, eine Windkraftanlage, eine Biogasanlage, eine Kraftwärmekopplungsanlage, eine Gasturbine, ein Dieselgenerator oder ein sonstiger, mechanisch betriebener Generator sein. Ein Speicher kann beispielsweise ein Pumpspeicher, ein Batteriespeicher oder dergleichen sein. All diese Teilnehmer werden an dem Versorgungsnetz betrieben und sind in der Regel über einen Verbrauchsmengenzähler unmittelbar oder mittelbar mit dem Versorgungsnetz verbunden.

Eine Vielzahl von solchen Teilnehmern lässt sich fernsteuern. Hierzu steuert zumindest eine Steuereinrichtung zumindest einen jeweiligen Teilnehmer. Eine Steuereinrichtung kann beispielsweise ein Smart-Home-Controller, ein Wechselrichter, ein Gleichrichter, eine Ladesteuereinrichtung oder dergleichen sein. Zwischen zumindest einem Teilnehmer und zumindest einer Steuereinrichtung kann eine Kommunikationsverbindung, insbesondere eine Funkverbindung etabliert sein. Auch eine drahtgebundene Verbindung kann etabliert sein.

Mit Hilfe der Steuereinrichtung lässt sich ein Teilnehmer ein- und ausschalten bzw. der Energiefluss (gegebenenfalls stufenlos) beeinflussen. Ferner ist es möglich, dass eine Steuereinrichtung einen Betriebsmodus eines Teilnehmers einstellt.

Um nun zu ermöglichen, dass über die Steuereinrichtung gezielt Eingriff in Energieflüsse entlang des Versorgungsnetzes genommen wird, ist es notwendig zu wissen, über welche Steuereinrichtung ein Energiefluss an welchen Verbrauchsmengenzähler einstellbar ist. Daher soll eine informationstechnische Verknüpfung, mithin eine Zuordnung zwischen einem Verbrauchsmengenzähler und einer Steuereinrichtung etabliert werden. Diese Zuordnung soll automatisiert erfolgen.

Es wird daher vorgeschlagen, dass von der Steuereinrichtung an den zumindest einen Teilnehmer ein Steuerbefehl ausgesendet wird. In Reaktion auf diesen Steuerbefehl wird der Teilnehmer mit höchster Wahrscheinlichkeit sein Verhalten ändern und insbesondere seine bezogene oder abgegebene Leistung verändern.

Empfängt der Teilnehmer einen Steuerbefehl, so verändert sich sein elektrisches Verhalten. Diese Veränderung des elektrischen Verhaltens führt dazu, dass sich in der elektrischen Verbindung zwischen dem Versorgungsnetz und dem Teilnehmer ein elektrischer Parameter (Strom, Spannung, Phasenlagen, Energieflussrichtung, etc.) verändert. Da der Teilnehmer über einen Verbrauchsmengenzähler mit dem Versorgungsnetz verbunden ist, kann eine solche Veränderung an dem Verbrauchsmengenzähler detektiert werden.

Es wird vorgeschlagen, dass Zählwerte des Verbrauchsmengenzählers in der Steuereinrichtung empfangen werden. Der Verbrauchsmengenzähler, beispielsweise ein Smart-Meter oder ein intelligentes Messsystem (Smart-Meter mit Smart-Meter-Gateway oder Multi-Utility-Communication Gateway) erfasst über Zählwerte elektrische Parameter zwischen dem Versorgungsnetz und dem Teilnehmer. Die Zählwerte können beispielsweise eine Spannung, ein Strom, eine Stromflussrichtung, eine elektrische Leistung, eine Phasenlage, eine Leistungsflussrichtung und/oder eine Energie über ein Zeitintervall von beispielsweise wenigen Sekunden bis einige Minuten sein.

In der Steuereinrichtung ist ein Prozess etabliert, der Kenntnis darüber hat, welche Steuerbefehle zu welchen Veränderungen an dem Teilnehmer führen. Insbesondere kann eine Kenntnis darüber existieren, wie sich das elektrische Verhalten eines Teilnehmers abhängig von einem Steuerbefehl verändert sollte. Es können also Sollwerte für elektrische Parameter definiert sein, die als Erwartungswerte gespeichert sind. Wenn in Reaktion auf einen Steuerbefehl der Teilnehmer sein Verhalten ändert, so hat dies Auswirkung auf die Zählwerte des Verbrauchmengenzählers. In der Steuereinrichtung sind zugeordnet zu einem Steuerbefehl Erwartungswerte für die Zählwerte des Verbrauchsmengenzählers hinterlegt.

Als einfachstes Beispiel kann z.B. ein Steuerbefehl "An" betrachtet werden. Für diesen Steuerbefehl "An" kann als Erwartungswert eine Sprungfunktion angenommen werden. Das heißt, dass in Reaktion auf den Steuerbefehl "An" an dem Verbrauchsmengenzähler, der mit dem Teilnehmer verbunden ist, ein Sprung der elektrischen Leistung feststellbar sein müsste, und mithin der entsprechenden Zählwerte.

Um nun festzustellen, an welchem Verbrauchsmengenzähler ein Steuerbefehl der Steuereinrichtung eine Auswirkung hat, wird vorgeschlagen, dass die empfangenen Zählwerte mit von den Steuerbefehlen abhängigen, in der Steuereinrichtung gespeicherten Erwartungswerten korreliert werden. Hierbei eignet sich insbesondere zeitliche Korrelation zwischen den Erwartungswerten und den Zählwerten, bevorzugt über einen Betrachtungszeitraum von beispielsweise wenigen Sekunden bis wenigen Minuten. Eine Korrelation kann beispielsweise eine Kreuzkorrelation sein. Insbesondere eine numerische Kreuzkorrelation, beispielsweise mittels Sum of Square Difference (SSD) oder dergleichen ist möglich.

In der Steuereinrichtung werden Zählwerte bevorzugt von einer Mehrzahl von Verbrauchsmengenzählern empfangen. Um festzustellen, welchem Verbrauchsmengenzähler eine Steuereinrichtung zugeordnet ist, wird die Korrelation ausgewertet. Korrelieren die Zählwerte mit den Erwartungswerten, so bedeutet dies, dass der Steuerbefehl mit hoher Wahrscheinlichkeit an einem Teilnehmer durchgeführt wurde, dessen Verbrauchsmengenzähler der Steuereinrichtung zugeordnet werden kann. Daher erfolgt gegenständlich das Zuordnen des Verbrauchsmengenzählers zu der Steuereinrichtung abhängig von der Korrelation. Hierbei ist es insbesondere möglich, dass ein Betrag einer Kreuzkorrelationsfunktion ausgewertet wird und beim Überschreiten eines Grenzwertes die Zuordnung erfolgt.

Es versteht sich, dass eine solche Zuordnung statistisch basiert ist. Zur Erhöhung der Wahrscheinlichkeit, dass eine so durchgeführte Zuordnung korrekt ist, wird es sinnvoll sein, die Korrelation über eine Vielzahl von Steuerbefehlen und/oder Zeitfenstern, insbesondere mit Hilfe eines gleitenden Zeitfensters durchzuführen und stetig neu zu evaluieren, welche Zuordnung am wahrscheinlichsten ist.

Das gegenständliche Verfahren ermöglicht somit, festzustellen, welcher Verbrauchsmengenzähler über welche Steuereinrichtung beeinflussbar ist, insbesondere an welchem Verbrauchsmengenzähler eine Steuereinrichtung einen elektrischen Parameter beeinflussen kann. Diese Zuordnung gemäß des Gegenstandes kommt ohne einen manuellen Eingriff, insbesondere die Eingabe von Kennwörtern oder eine manuelle Verdrahtung oder funktechnische Kopplung aus. Es ist nicht notwendig, manuell einen Pairing-Prozess zwischen dem Verbrauchsmengenzähler und der Steuereinrichtung herzustellen.

Das gegenständliche Verfahren setzt voraus, dass eine kommunikationstechnische Verbindung zwischen dem Verbrauchsmengenzähler und der Steuereinrichtung, mittelbar oder unmittelbar besteht. Eine solche Verbindung kann insbesondere funktechnisch sein und der Verbrauchsmengenzähler kann beispielsweise über eine Kommunikationseinheit seine Zählwerte zur Verfügung stellen. In einer Umgebung mit einer Mehrzahl an Verbrauchsmengenzählern können diese jeweils einzeln ihre Zählwerte insbesondere über eine Luftschnittstelle zur Verfügung stellen. Die Steuereinrichtung kann diese Zählwerte insbesondere über die Luftschnittstelle empfangen, insbesondere unmittelbar oder mittelbar über Umwege, beispielsweise von einer räumlich entfernten Zentrale oder dergleichen.

Die Verbrauchsmengenzähler teilen in Abständen, insbesondere regelmäßig beispielsweise Energiemesswerte oder sonstige elektrische Parameter, nachfolgend auch Zählwerte genannt, über eine Schnittstelle mit. Eine solche Schnittstelle kann beispielsweise RS232, Wireless M-BUS, S-NULL, Impulsausgang, Powerline, Ethernet, Bluetooth oder dergleichen sein. Die Steuereinrichtung kann die Zählwerte entweder über dieselbe Schnittstelle empfangen, über die sie ausgesendet wurden oder mittelbar über Umwege, beispielsweise von einer zwischengeschalteten, räumlich entfernten Zentrale oder dergleichen. Es ist nicht notwendig, dass eine unmittelbare Verbindung zwischen der Steuereinrichtung und dem Verbrauchsmengenzähler gebildet ist. Die Zählwerte können von dem Verbrauchsmengenzähler im Broadcast oder im Multicast ausgesendet werden und Zählwerte eines Verbrauchsmengenzählers können von einer Mehrzahl von Steuereinrichtungen empfangen werden.

Gemäß einem Ausführungsbeispiel wird vorgeschlagen, dass die empfangenen Zählwerte mit den Erwartungswerten fortlaufend korrigiert werden und dass Zuordnungen dynamisch abhängig von aktuellen und/oder kumulierten Korrelationen verändert werden. So ist es beispielsweise möglich, den Betrag der Korrelationsfunktion zu normalisieren. Normalisierte Korrelationswerte können dann miteinander verglichen werden. Sind mehrere Verbrauchsmengenzähler vorhanden, so kann für jeden dieser Verbrauchsmengenzähler in der Steuereinrichtung ein Wert der Korrelation bestimmt werden. Ist dieser Wert normalisiert, so kann ein Vergleich der Werte erfolgen.

Auch ist es möglich, für jeweils einen der Verbrauchsmengenzähler den Korrelationswert zu bestimmen und zu überprüfen, ob dieser Wert einen Grenzwert überschreitet. In diesem Fall kann eine Zuordnung zwischen dem Verbrauchsmengenzähler und der Steuereinrichtung erfolgen. Da ein Teilnehmer über zwei oder mehr Verbrauchsmengenzähler an einem Versorgungsnetz betrieben sein kann, ist es durchaus denkbar, dass die Steuereinrichtung über einen Steuerbefehl eine Veränderung an Zählwerten an einer Mehrzahl an Verbrauchsmengenzählern bewirkt, wobei diese Änderungen zu einer Erhöhung des Betrags der Korrelation führen.

Auch ist es möglich, dass ein Betrag einer Korrelationsfunktion abhängig von der Zeitspanne seit dem Steuerbefehl reduziert wird. Somit werden erfasste Korrelationen zeitlich gewichtet. So gewichtete Korrelationsbeträge können kumuliert werden und eine Zuordnung kann abhängig von einer so gebildeten Summe von Korrelationsbeträgen sein.

Durch die fortlaufende Überprüfung der Korrelation kann in einem sich dynamisch ändernden Umfeld stets eine hochverlässige Zuordnung zwischen Verbrauchsmengenzähler und Steuereinrichtung erfolgen. Es ist durchaus denkbar, dass ein Teilnehmer mobil betrieben wird, so dass er zu einem ersten Zeitpunkt an einem ersten Verbrauchsmengenzähler angeschlossen ist und zu einem zweiten Zeitpunkt an einem zweiten Verbrauchsmengenzähler. Erfolgt ein Steuerbefehl für einen solchen Teilnehmer, führt dies in dem ersten Zeitpunkt zu einer Veränderung der Zählwerte des ersten Verbrauchsmengenzählers und in dem zweiten Zeitpunkt zu einer Veränderung der Zählwerte des zweiten Verbrauchsmengenzählers. Die Steuereinrichtung müsste in dem ersten Zeitpunkt mit dem ersten Verbrauchsmengenzähler zugeordnet werden und in dem zweiten Zeitpunkt mit dem zweiten Verbrauchsmengenzähler. Solche Veränderungen lassen sich dynamisch abbilden, in dem die Zuordnung dynamisch abhängig von aktuellen Korrelationen verändert wird. Auch lassen sich im Sinne eines selbstlernenden Algorithmus aktuelle Korrelationen mit Werten aus der Vergangenheit vergleichen oder auf dieser Basis Prognosen für die gegebenenfalls zeitlich eingeschränkte Korrelation in der Zukunft ermitteln. Somit können zeitliche Intervalle festgelegt werden, in denen Korrelationen beobachtet werden. Korrelationen außerhalb der Intervalle können bei der dynamischen Zuordnung unberücksichtigt bleiben.

Gemäß einem Ausführungsbeispiel wird vorgeschlagen, dass die Erwartungswerte abhängig von Sendezeitpunkten der Steuerbefehle und/oder Informationen zu einer Leistung des Teilnehmers und/oder einem Betriebsverhalten des Teilnehmers sind. Wird ein "An"-Befehl ausgesendet, so ist ab diesem Zeitpunkt mit einem Sprung in den Zählwerten an dem verknüpften Verbrauchsmengenzähler zu rechnen. Somit ist ein Erwartungswert abhängig von einem Sendezeitpunkt. Auch ein "Aus"-Befehl ist mit einem Erwartungswert einer inversen Sprungfunktion verknüpft und zum Zeitpunkt des Sendens des "Aus"-Steuerbefehls sollte die Zählwerte eines zugeordneten Verbrauchsmengenzählers einen solchen inversen Sprung aufweisen.

Auch eine Leistung eines Teilnehmers kann relevant sein. Die Leistung des Teilnehmers kann sich in dem Betrag des Zählwertes niederschlagen. Auch ein solcher Betrag kann in einem Erwartungswert hinterlegt sein.

Auch ein Betriebsverhalten eines Teilnehmers kann relevant sein. Ist beispielsweise bekannt, dass ein Teilnehmer ein bestimmtes Leistungsprofil über eine gewisse Zeit hat, kann dieses Profil in den Erwartungswerten hinterlegt werden. Ein Abgleich der Zählwerte mit solchen Erwartungswerten führt mit einer hohen Genauigkeit zu einer korrekten Zuordnung zwischen Verbrauchsmengenzähler und Steuereinrichtung.

Gemäß einem Ausführungsbeispiel wird vorgeschlagen, dass die Erwartungswerte eine zeitliche Reihe von Erwartungswerten umfassen. Insbesondere können diskrete Erwartungswerte in Intervallen, beispielsweise in Abständen von wenigen Sekunden eine zeitliche Reihe bilden. Das gleiche gilt für Zählwerte, die ebenfalls eine zeitliche Reihe von Messwerten umfassen können. Solche Messwerte können insbesondere elektrische Parameter, wie beispielsweise Energiemengen, Leistungsmengen, Strommesswerte oder Spannungsmesswerte oder dergleichen umfassen.

Gemäß einem Ausführungsbeispiel wird vorgeschlagen, dass die Steuerbefehle Zu- und/oder Abschaltbefehle für den Teilnehmer umfassen und/oder dass die Steuerbefehle zumindest eine Leistungsvorgabe für den Teilnehmer umfassen. Ist in einem Steuerbefehl eine Leistungsvorgabe enthalten, so kann dieser Leistungswert insbesondere den Betrag eines Erwartungswertes beeinflussen.

Gemäß einem Ausführungsbeispiel wird vorgeschlagen, dass zumindest abhängig von der Zuordnung eine von der Steuereinrichtung an den Teilnehmer an jeweils einem Verbrauchsmengenzähler beinflussbare Leistung bestimmt wird. Durch die Zuordnung kann festgestellt werden, welchen Verbrauchsmengenzähler eine Steuereinrichtung zugeordnet ist und/oder welches elektrische Verhalten an welchem Verbrauchsmengenzähler durch eine bestimmte Steuereinrichtung beeinflusst werden kann. Ist beispielsweise bekannt, welche Summe von Teilnehmern über eine bestimmte Steuereinrichtung an eine bestimmten Verbrauchsmengenzähler beeinflusst werden kann, kann bestimmt werden, wie hoch beispielsweise die Leistung ist, die eine Steuereinrichtung an dem zugeordneten Verbrauchsmengenzähler beeinflussen kann. Diese Information kann relevant sein für eine Netzsteuerung und insbesondere eine Netzstabilisierung.

Zur Netzführung kann es sinnvoll sein, die Steuereinrichtungen extern anzusteuern, um so Leistungsflüsse in dem Versorgungsnetz an bestimmten Punkten zu beeinflussen, insbesondere an den Verknüpfungspunkten der Verbrauchsmengenzähler mit dem Versorgungsnetz. Ist bekannt, welche Steuereinrichtung welchem Verbrauchsmengenzähler zugeordnet ist, kann durch gezielte Ansteuerung der jeweiligen Steuereinrichtung auch der Leistungsfluss an dem jeweilig Verknüpfungspunkt des zugeordneten Verbrauchsmengenzählers beeinflusst werden.

Gemäß einem Ausführungsbeispiel wird vorgeschlagen, dass zumindest einem Verbrauchsmengenzähler ein Verknüpfungspunkt zwischen einem Hausverteilnetz und einem öffentlichen Versorgungsnetz zugeordnet ist und dass der Steuereinrichtung abhängig von der Zuordnung eine an dem Verknüpfungspunkt beeinflussbare Leistung zugeordnet wird. Diese beeinflussbare Leistung kann beispielsweise von einer räumlich entfernten Zentrale der Steuereinrichtung mitgeteilt werden. Über die externe Zentrale kann so eine Netzführung erfolgen, in dem eine Leistungsflussveränderung an dem Verknüpfungspunkt über die Steuereinrichtung eingestellt werden kann und somit Leistungsflüsse in dem öffentlichen Versorgungsnetz beeinflusst werden können.

Gemäß einem Ausführungsbeispiel wird vorgeschlagen, dass die Steuereinrichtung einen Vorgabewert für eine Veränderung einer Leistung an einem Verknüpfungspunkt empfängt und abhängig von dem Vorgabewert zumindest einen Teilnehmer ansteuert. Für den Fall der aktiven Netzbeeinflussung kann von einem externen Steuerrechner eine Vorgabe für eine Veränderung einer Leistung an einem bestimmten Verknüpfungspunkt an die Steuereinrichtung übermittelt werden. In der Steuereinrichtung kann dann abhängig von der Zuordnung zu dem jeweiligen Verbrauchsmengenzähler eine entsprechende Anzahl an Steuerbefehlen abgesetzt werden, um zumindest einen Teilnehmer anzusteuern und den Vorgabewert für die veränderte Leistung an dem Verknüpfungspunkt einzuhalten.

Gemäß einem Ausführungsbeispiel wird vorgeschlagen, dass zumindest drei Steuereinrichtungen kaskadiert verschaltet sind, so dass zumindest eine erste übergeordnete Steuereinrichtung zumindest zwei voneinander unabhängige, nachgeordnete Steuereinrichtungen ansteuert und dass die Zuordnung zu zumindest einer der nachgeordneten Steuereinrichtungen und zumindest einer der übergeordneten Steuereinrichtungen erfolgt. In einem solchen Fall kann beispielsweise durch eine übergeordnete Steuereinrichtung eine nachgeordnete Steuereinrichtung beeinflusst werden. Die übergeordnete Steuereinrichtung kann zumindest zwei nachgeordnete Steuereinrichtungen beeinflussen. Jede dieser nachgeordneten Steuereinrichtungen kann jeweils zumindest einen Teilnehmer beeinflussen. Die beeinflussten Teilnehmer können über verschiedene Verbrauchsmengenzähler mit dem Versorgungsnetz verknüpft sein. Wird von einer nachgeordneten Steuereinrichtung ein Steuerbefehl abgesetzt, so führt dies zu einer Veränderung der Zählwerte an dem zugeordneten Verbrauchsmengenzähler. Die Korrelation des Steuerbefehls zu der Veränderung des Zählwertes kann dann in den nachgeordneten Steuereinrichtungen als auch der übergeordneten Steuereinrichtung detektiert werden und sowohl die übergeordnete als auch die nachgeordnete Steuereinrichtung kann dem jeweiligen Verbrauchsmengenzähler zugeordnet werden.

Gemäß einem Ausführungsbeispiel wird vorgeschlagen, dass der Verbrauchsmengenzähler einen Energiemengenzähler, insbesondere einen elektrischen Energiemengenzähler, insbesondere ein Smart-Meter oder ein intelligentes Messsystem ist.

Auch wird vorgeschlagen, wie oben bereits beschrieben, dass der Verbrauchsmengenzähler in Kommunikationsverbindung mit zumindest einer Steuereinrichtung ist. Diese Kommunikationsverbindung kann unmittelbar oder mittelbar über einen beispielsweise zwischengeschalteten zentralen Server sein. Die Kommunikationsverbindung erfolgt insbesondere über die Luftschnittstelle.

Gemäß einem Ausführungsbeispiel wird vorgeschlagen, dass zumindest ein Verbrauchsmengenzähler im Hausverteilnetz angeordnet ist und/oder dass zumindest ein Verbrauchsmengenzähler in einem öffentlichen Versorgungsnetz angeordnet ist. Die Verbrauchsmengenzähler können somit sowohl in einer Hausunterverteilung als auch unmittelbar in oder an dem öffentlichen Versorgungsnetz angeordnet sein.

Gemäß einem Ausführungsbeispiel wird vorgeschlagen, dass der Teilnehmer ein Verbraucher, insbesondere ein elektrischer Verbraucher ist. Auch wird vorgeschlagen, dass der Teilnehmer ein Erzeuger, insbesondere ein elektrischer Erzeuger, beispielsweise eine Fotovoltaik Anlage, einen Windkraftanlagen, eine KWK-Anlage, eine Biomasseanlage oder dergleichen ist. Auch wird vorgeschlagen, dass der Teilnehmer ein Speicher, insbesondere ein elektrischer Speicher ist. Das gegenständlich Verfahren lässt sich insbesondere auch in einer gemischten Umgebung einsetzen, in dem verschiedene Teilnehmer, beispielsweise Lasten (Verbraucher, Erzeuger und/oder Teilnehmer) gleichzeitig betrieben werden.

Ein weiterer Aspekt ist ein System nach Anspruch 15. Dieses System umfasst eine Steuereinrichtung, zumindest einen Verbrauchsmengenzähler und einen Teilnehmer in einem Versorgungsnetz, wobei die Steuereinrichtung in Wirkverbindung mit dem Teilnehmer ist und wobei der Verbrauchsmengenzähler in Kommunikationsverbindung mit der Steuereinrichtung ist.

Der Gegenstand betrifft auch ein Computerprogramm, das Programmanweisungen umfasst, die einen Prozessor zur Ausführung und/oder Steuerung des hier beschriebenen Verfahrens veranlassen, wenn das Computerprogramm auf dem Prozessor läuft.

Unter einem Prozessor sollen in dieser Spezifikation unter anderem Kontrolleinheiten, Mikroprozessoren, Mikrokontrolleinheiten wie Mikrocontroller, digitale Signalprozessoren (DSP), Anwendungsspezifische Integrierte Schaltungen (ASICs) oder Field Programmable Gate Arrays (FPGAs) verstanden werden. Dabei können entweder alle Schritte des Verfahrens gesteuert werden, oder alle Schritte des Verfahrens ausgeführt werden, oder ein oder mehrere Schritte gesteuert und ein oder mehrere Schritte ausgeführt werden. Das Computerprogramm kann beispielsweise über ein Netzwerk wie das Internet, ein Telefon- oder Mobilfunknetz und/oder ein lokales Netzwerk verteilbar sein. Das Computerprogramm kann zumindest teilweise Software und/oder Firmware eines Prozessors sein. Es kann gleichermaßen zumindest teilweise als Hardware implementiert sein. Das Computerprogramm kann beispielsweise auf einem computerlesbaren Speichermedium gespeichert sein, z.B. einem magnetischen, elektrischen, elektro-magnetischen, optischen und/oder andersartigen Speichermedium. Das Speichermedium kann beispielsweise Teil des Prozessors sein, beispielsweise ein (nicht-flüchtiger oder flüchtiger) Programmspeicher des Prozessors oder ein Teil davon. Das Speichermedium ist beispielsweise gegenständlich, also greifbar, und/oder nicht-transitorisch. Das Computerprogramm wird bevorzugt auf einem Prozessor in der Steuereinrichtung ausgeführt.

Nachfolgend wird der Gegenstand anhand einer Ausführungsbeispiele zeigenden Zeichnung näher erläutert:
- Fig. 1: ein System zur Steuerung von Leistungsflüssen in einem Netz;
- Fig. 2: eine mögliche Korrelation empfangener Zählwerte mit Erwartungswerten;
- Fig. 3: eine weitere mögliche Korrelation zwischen empfangenen Zählwerten und Erwartungswerten;
- Fig. 4: eine Anordnung mit Steuereinrichtung, Teilnehmer und Zähleinrichtung gemäß einem Ausführungsbeispiel;
- Fig. 5: eine weitere Anordnung von Steuereinrichtung, Teilnehmer und Zähleinrichtung gemäß einem weiteren Ausführungsbeispiel;
- Fig. 6: eine weitere Anordnung von Steuereinrichtung, Teilnehmer und Zähleinrichtung gemäß einem Ausführungsbeispiel.

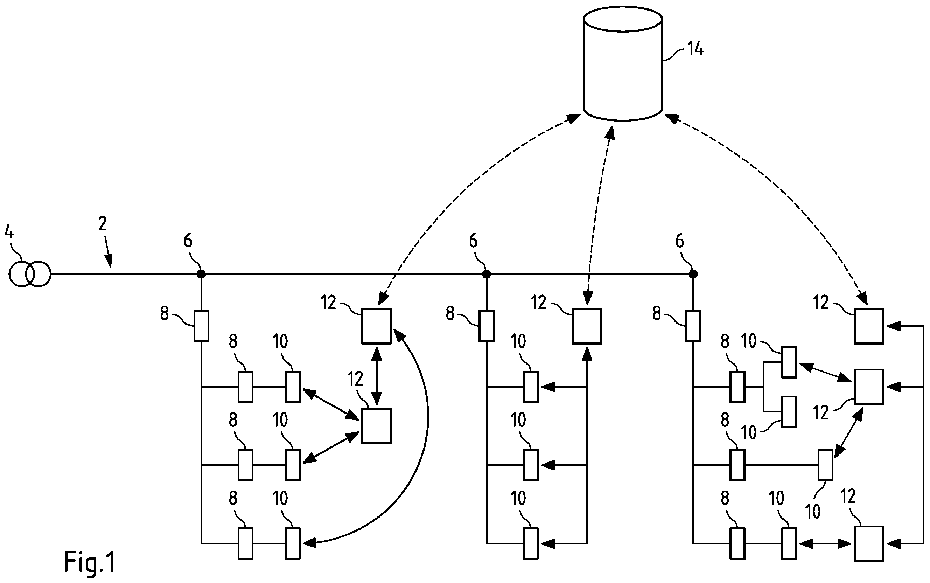

Fig. 1 zeigt ein System zur Steuerung von Leistungsflüssen in einem Energieversorgungsnetz.

Ein Energieversorgungsnetz kann beispielsweise einen niederspannungsseitigen Versorgungsstrang 2, der über Trafo 4 mit einem Mittelspannungsnetz verbunden ist, aufweisen. An dem Versorgungsstrang 2 können Verknüpfungspunkte 6 vorgesehen sein, über die Hausverteilnetze mit dem Versorgungsstrang 2 verbunden sind.

In den jeweiligen Hausverteilnetzen, die natürlich auch industrielle Anlagen sein können, können ein oder mehrere Zähler 8 angeordnet sein, die elektrische Parameter wie eine elektrische Leistung und/oder eine Leistungsflussrichtung und/oder einen Strom und/oder eine Stromrichtung und/oder eine Spannung und/oder eine Phasenlage und/oder eine elektrische Energiemenge messen können. Die Zähler 8 sind Verbrauchsmengenzähler und erfassen elektrische Parameter, insbesondere eine elektrische Energie. Die Zähler 8 sind dabei bevorzugt Smart Meter oder intelligente Messsysteme.

Die Zähler 8 erfassen elektrische Leistungsflüsse zu und/oder von Teilnehmern 10, die jeweils zumindest einem Zähler 8 zugeordnet sind. Die Teilnehmer 10 können dabei elektrische Lasten, Speicher und/oder Erzeuger sein.

Die Teilnehmer 10 haben schwankende Leistungsprofile, so dass sich deren Einfluss auf den Versorgungsstrang mit der Zeit verändert. Es kann notwendig sein, z.B. zur Netzstabilisierung, eine gezielte Ansteuerung von Teilnehmern 10 zu ermöglichen, um die Leistungsflüsse in dem Versorgungsstrang 2 beeinflussen zu können. Hierzu können Steuereinrichtungen 12, sogenannte Energiemanagementsysteme vorgesehen sein, die einen steuernden Einfluss auf die Teilnehmer 10 haben.

Steuereinrichtungen 12 können beispielsweise Smart Home Zentralen, Wechsel- und Umrichter von Erzeugungsanlagen, Ladesteuerschaltungen, Maschinensteuerungen oder dergleichen sein. Mit Hilfe der Steuereinrichtungen 12 können die Teilnehmer 10 hinsichtlich ihrer Leistungsaufnahmen und/oder -abgabe beeinflusst werden.

Veränderte Leistungen an den Teilnehmern 10 führen zu veränderten Leistungsflüssen an den Zählern 8 und mithin an den Verknüpfungspunkten 6.

In der Regel ist bekannt, welche Zähler 8 an welchem Verknüpfungspunkt 6 betrieben sind, nicht bekannt ist jedoch, welche Steuereinrichtungen 12 Einfluss auf Teilnehmer 10 haben, die einem bestimmten Zähler 8 zugeordnet sind.

In der Figur 1 sind zwischen den Teilnehmern 10 und den Steuereinrichtungen 12 Pfeile angedeutet, die eine Wirkverbindung zwischen einer Steuereinrichtung 12 und einem Teilnehmer 10 anzeigen, d.h. dass eine jeweilige Steuereinrichtung 12 Einfluss auf den Teilnehmer 10 über Schaltbefehle hat.

Es wäre wünschenswert, über eine zentrale Instanz 14, beispielsweise einem zentralen Steuerrechner, Einfluss auf Leistungsflüsse nehmen zu können, in dem die Steuereinrichtungen 12 gezielt angesprochen werden, um somit an den Verknüpfungspunkten 6 einen veränderten Leistungsfluss zu erzielen. Hierzu muss aber bekannt sein, welche Steuereinrichtung 12 mit welchem Zähler 8 logisch verknüpft ist. Insbesondere muss bekannt sein, ob über eine Steuereinrichtung 12 an einem bestimmten Zähler 8 eine Leistungsflussveränderung ermöglicht werden kann oder nicht. Hierzu muss eine Kenntnis darüber existieren, welcher Zähler 8 mit welcher Steuereinrichtung 12 verknüpft ist. Gegenständlich wird nun vorgeschlagen, eine derartige Zuordnung eines Verbrauchsmengenzählers 8 zu einer Steuereinrichtung 12 automatisiert zu ermöglichen.

Es wird vorgeschlagen, dass Zählwerte der Verbrauchsmengenzähler 8 mit Erwartungswerten, die abhängig von Steuerbefehlen der Steuereinrichtung 12 sind, verglichen werden, um so festzustellen, über welche Steuereinrichtung 12 an welchem Zähler 8 eine Beeinflussung eines Leistungsflusses möglich ist.

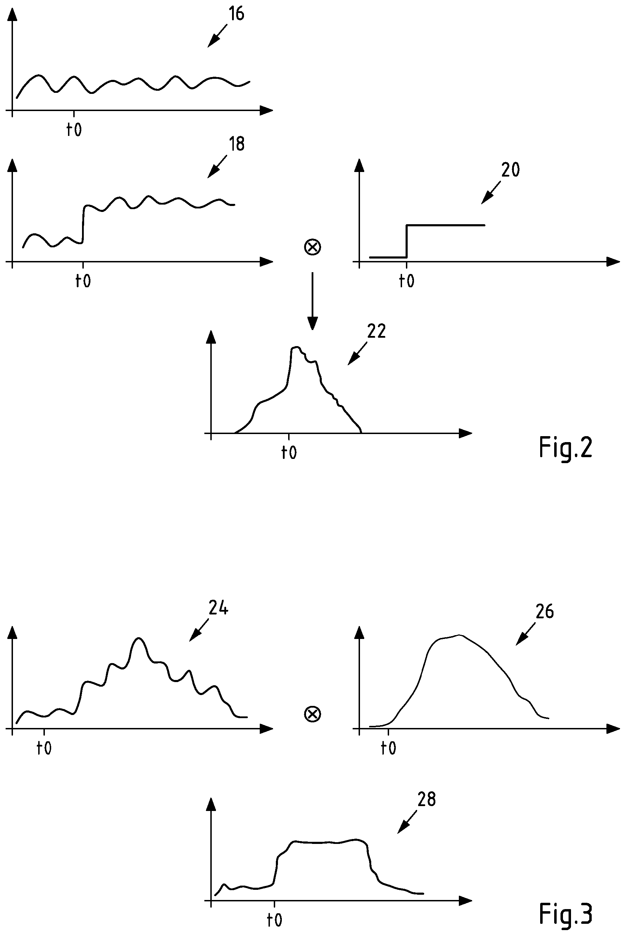

Fig. 2 zeigt eine derartige mögliche Korrelation. Fig. 2 zeigt einen ersten Verlauf 16 von Zählwerten eines Zählers 8. Die Zählwerte sind kontinuierlich dargestellt, sind aber bevorzugt zeitdiskrete Werte. Die nachfolgenden Diagramme zeigen allesamt kontinuierliche Wertverläufe, können aber ebenso durch zeitdiskrete Werte dargestellt werden. Der Verlauf der Zählwerte ist abhängig von der

Leistungsaufnahme oder -abgabe der an dem jeweiligen Zähler angeschlossenen Teilnehmer.

Im Falle eines Einschaltens eines Teilnehmers 10 an einem Zähler 8 kann dieser Zähler beispielsweise einen Verlauf 18 von Zählwerten liefern. Zu erkennen ist, dass zum Zeitpunkt t0 in dem Verlauf 18 ein Sprung vorhanden ist. Dieser Sprung kann bedingt durch ein Einschalten eines Teilnehmers 10 bedingt sein. Die Schwankung der Zählwerte kann durch Leistungsschwankungen des einen Teilnehmers 10 oder weiterer an dem Zähler 8 angeordneter Teilnehmer 10 bedingt sein.

Ist ein Steuersignal "Ein" zum Zeitpunkt t0 durch eine Steuereinrichtung 12 abgesetzt worden, so kann in dieser Steuereinrichtung 12 ein Erwartungswert 20 einem solchen Steuersignal zugeordnet werden. Mit Hilfe des Erwartungswertes 20, der ebenfalls einen Verlauf von Zählwerten repräsentieren kann, kann eine Auswirkung auf den Teilnehmer 10 insbesondere die Zählwerte am Zähler 8 durch ein bestimmtes Steuersignal simuliert werden.

Werden nun Verlauf 18 und Erwartungswert 20 miteinander korreliert, insbesondere kreuzkorreliert, so ergibt die Korrelationsfunktion 22 zum Zeitpunkt t0 ein Maximum. Dieses Maximum zum Zeitpunkt t0 ist bedingt durch die Korrelation des Verlaufs 18 mit dem Erwartungswert 20.

Ein Steuerbefehl kann jedoch nicht nur ein Ein- und Ausschaltbefehl sein, sondern beispielsweise auch eine Leistungsvorgabe für einen Teilnehmer 10 beinhalten. Ferner kann für einen Teilnehmer 10 ein Verlauf einer elektrischen Leistung über einen Zeitraum bekannt sein, sodass beispielsweise beginnend mit dem Einschaltzeitpunkt t0 der Verlauf der elektrischen Leistung mithin der Energie an dem Teilnehmer 10 bekannt sein kann.

Ein solches Szenario ist in der Fig. 3 dargestellt. In der Fig. 3 ist ein Verlauf 24 von Zählwerten eines Zählers 8 an einem Teilnehmer 10 dargestellt. Ein Erwartungswert 26 in einer Steuereinrichtung 12 kann für den entsprechenden Teilnehmer 10 hinterlegt sein. Der Erwartungswert 26 stellt startend mit dem Zeitpunkt t0 den Verlauf der Leistungsaufnahme und/oder der Energie des Teilnehmers 10 dar.

Wird ein entsprechender Teilnehmer 10 durch die Steuereinrichtung 12 angesteuert und ist dieser Teilnehmer 10 an dem Zähler 8 angeschlossen, der die Zählwerte 24 liefert, so ist der Verlauf der Zählwerte 24 korreliert mit dem Erwartungswert 26.

Eine Korrelationsfunktion 28 zeigt zum Zeitpunkt t0 einen starken Anstieg. Die Korrelation zwischen dem Verlauf 24 und dem Erwartungswert 26 erstreckt sich über einen längeren Zeitraum, so dass die Korrelationsfunktion 28 über einen längeren Zeitraum einen Wert hat, der über einem Grenzwert liegen kann.

Unter Verwendung der Erwartungswerte 20, 26 und der Verläufe der Zählwerte 18, 24 sowie der daraus errechneten Korrelationsfunktion 22, 28 kann eine Zuordnung von einem Zähler 8 zu einer Steuereinrichtung 12 erfolgen. Eine solche mögliche Zuordnung kann in einem System gemäß Figs. 1, 4, 5, 6 erfolgen.

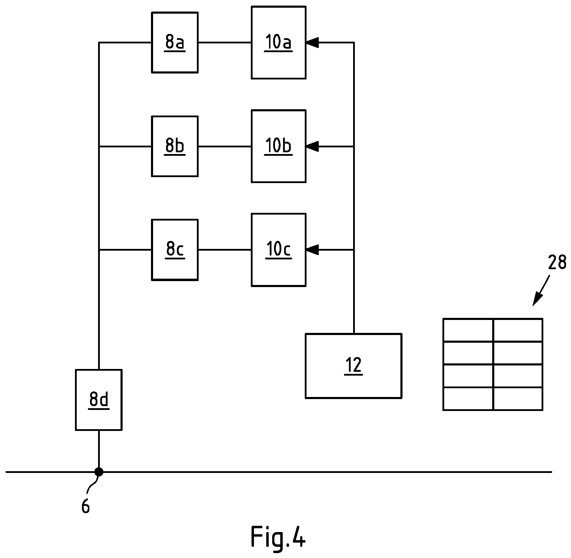

An einem Verknüpfungspunkt 6 kann gemäß Fig. 4 ein Zähler 8d ein Hausverteilnetz anschließen. Innerhalb eines Hausverteilnetzes können mehrere Zähler 8a-c vorgesehen sein, an denen jeweils ein Teilnehmer 10a-c angeordnet ist. Die Anzahl der Teilnehmer 10a-c sowie deren Zuordnung zu Zählern 8a-c sowie die Anzahl der Zähler 8a-c ist hier rein beispielhaft dargestellt. In der Fig. 4 ist jedem Teilnehmer 10 genau ein Zähler 8 zugeordnet.

Eine Steuereinrichtung 12 ist vorgesehen, mit der die Teilnehmer 10 angesteuert werden können. Es besteht eine Kommunikationsverbindung zwischen der Steuereinrichtung 12 und den Zählern 8a-d, wobei jedoch in der Steuereinrichtung 12 unbekannt ist, welcher der Teilnehmer 10 an welchem Zähler 8a-d angeordnet ist und somit auch unbekannt, welche Leistungsflüsse an welchem Zähler 8a-d die Steuereinrichtung 12 beeinflussen kann. In der Steuereinrichtung 12 sind Datensätze 28 mit Steuerbefehlen und zugehörigen Erwartungswerten für einzelne Teilnehmer 10a-c hinterlegt.

In der Steuereinrichtung 12 werden Zählwerte der Zähler 8a-d empfangen. Im Normalbetrieb, das heißt ohne einen Steuerbefehl an einen der Teilnehmer 10a-c, verlaufen die Zählwerte der Zähler 8a-d schwankend und für die Steuereinrichtung 12 in nicht nachvollziehbarer Weise.

Sobald die Steuereinrichtung 12 beispielsweise einen Steuerbefehl für den Teilnehmer 10a absetzt, kann gleichzeitig für den entsprechenden Steuerbefehl aus dem Datensatz 28 ein Erwartungswert geladen werden.

Anschließend korreliert die Steuereinrichtung 12 die von den Zählern 8a-d empfangenen Zählwerte mit diesem Erwartungswert.

Die Zählwerte des Zählers 8a korrelieren am meisten mit dem Erwartungswert, sodass die Korrelationsfunktion bzw. der Betrag der Korrelationsfunktion einen Grenzwert überschreitet. Eine solche Überschreitung kann als Indiz dafür gewertet werden, dass die Steuereinrichtung 12 mit dem Zähler 8a über den Teilnehmer 10a verknüpft ist. Insofern kann eine Zuordnung des Zählers 8a zu der Steuereinrichtung 12 erfolgen.

Die Zählwerte der Zähler 8b und 8c werden mit hoher Wahrscheinlichkeit nicht mit dem Erwartungswert korrelieren, sodass die Steuereinrichtung 12 zunächst nur dem Zähler 8a zugeordnet wird. Darüber hinaus empfängt die Steuereinrichtung 12 jedoch auch Zählwerte des Zählers 8d. Da der Zähler 8d die durch den Steuerbefehl veränderte Leistung des Teilnehmers 10a misst, wird der Verlauf der Zählwerte des Zählers 8d mit den Erwartungswerten in der Steuereinrichtung 12 korrelieren und auch hier wird eine Korrelationsfunktion bzw. ein Betrag der Korrelationsfunktion einen Grenzwert überschreiten und eine Zuordnung des Zählers 8d zu der Steuereinrichtung 12 kann erfolgen.

Dasselbe Verfahren kann mit Steuerbefehlen für die Teilnehmer 10b und 10c erfolgen, sodass nach dem Absetzen der jeweiligen Steuerbefehle mit einer gewissen Wahrscheinlichkeit darauf geschlossen werden kann, dass die Steuereinrichtung 12 auch mit den Zählern 8b-c verknüpft ist.

Je häufiger und je mehr Steuerbefehle an den Teilnehmern 10a-c durchgeführt werden und die daraufhin gemessenen Zählwerte der Zähler 8a-d mit den Erwartungswerten in der Steuereinrichtung 12 korrelieren, desto sicherer kann darauf geschlossen werden, dass die Steuereinrichtung 12 mit einem der Zähler 8a-d verknüpft ist.

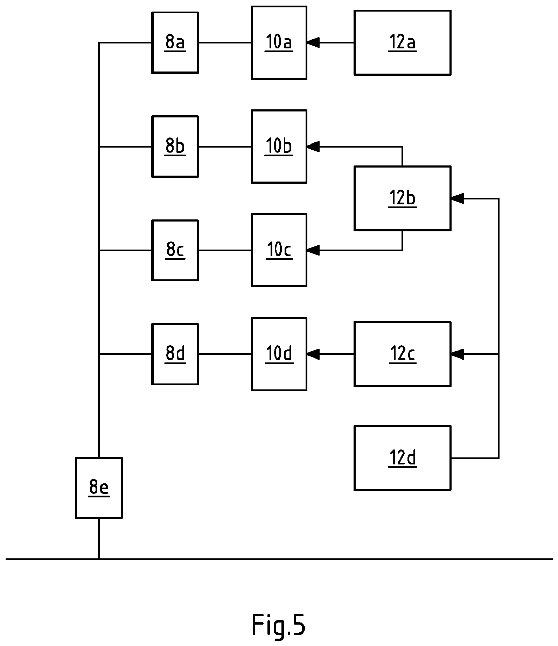

Fig. 5 zeigt ein weiteres Ausführungsbeispiel. Hierbei sind die Steuereinrichtungen 12a-d jedoch nicht allen Teilnehmern 10a-d zugeordnet, mithin nicht allen Zählern 8a-e.

Die Steuereinrichtung 12a kann einen Steuerbefehl für den Teilnehmer 10a in der beschriebenen Weise absetzen. Die Steuereinrichtung 12a empfängt Zählwerte der Zähler 8a-e. Die Veränderung der Zählwerte durch den Steuerbefehl korreliert mit dem entsprechenden Erwartungswert in der Steuereinrichtung 12a. Somit kann nach Absetzen des Steuerbefehls der Steuereinrichtung 12a durch Korrelation mit den Zählwerten der Zähler 8a-e festgestellt werden, dass eine Zuordnung zwischen der Steuereinrichtung 12a und dem Zähler 8a sowie dem Zähler 8e sinnvoll ist. Die Steuereinrichtungen 12b-d "sehen" zwar auch die Veränderung der Zählwerte an dem Zähler 8e, diese Veränderung korreliert aber nicht mit Erwartungswerten in den Steuereinrichtungen 12b-d, da diese keinen entsprechenden Steuerbefehl abgesetzt haben.

Die Steuereinrichtung 12b kann Steuerbefehle für den Teilnehmer 10b absetzen. Durch Korrelation der Zählwerte der Zähler 8a-e mit den Erwartungswerten kann die Steuereinrichtung 12b dem Zähler 8b zugeordnet werden.

Auch kann die Steuereinrichtung 12b den Teilnehmer 10c ansteuern. Bei einer solchen Ansteuerung kann durch einen entsprechenden Erwartungswert in der Steuereinrichtung 12b festgestellt werden, dass diesem dem Zähler 8c zugeordnet werden kann.

Die Steuerbefehle für die Teilnehmer 10b und c führen auch zu veränderten Zählwerten in dem Zähler 8e. Auch die Zählwerte dieses Zählers 8e führen zu einer Korrelation mit den Erwartungswerten in der Steuereinrichtung 12b, dass die Steuereinrichtung 12b auch dem Zähler 8e zugeordnet werden kann.

Für die Steuereinrichtung 12c und die Zähler 8d und e gilt das für die Steuereinrichtung 12a und die Zähler 8a und e Gesagte gleichermaßen.

Die Steuereinrichtungen 12b, c können kaskadiert mit der Steuereinrichtung 12d verschaltet sein. Somit kann die Steuereinrichtung 12d mittelbar über die Steuereinrichtung 12b und c Steuerbefehle für die Teilnehmer 10b, c und d absetzen.

Anhand der Steuerbefehle und der daraus resultierenden Veränderung der Zählwerte kann in der Steuereinrichtung 12d festgestellt werden, dass diese den Zählern 8b, c, d und e zugeordnet werden kann, nicht jedoch dem Zähler 8a.

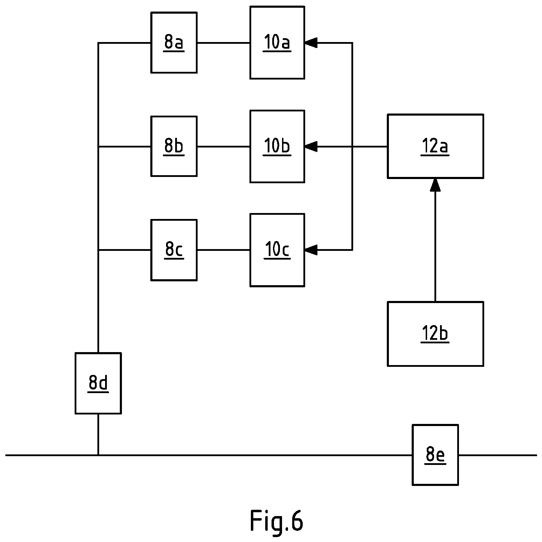

Fig. 6 zeigt ein weiteres Ausführungsbeispiel, bei dem die Steuereinrichtung 12a die Zählwerte der Zähler 8a-d empfängt. Durch Absetzen von Steuerbefehlen für die Teilnehmer 8a-c kann festgestellt werden, dass die Steuereinrichtung 12a den Zählern 8a -d zugeordnet werden kann.

Die Steuereinrichtung 12b kann die Steuereinrichtung 12a ansteuern und empfängt neben den Zählwerten der Zähler 8a-d auch noch die Zählwerte des Zählers 8e. Durch Absetzen von Steuerbefehlen mittelbar über die Steuereinrichtung 12a kann festgestellt werden, dass die Steuereinrichtung 12b den Zählern 8a-e zugeordnet ist. Somit kann die Steuereinrichtung 12b Leistungsflüsse an den Anschlusspunkten der Zähler 8a-e über entsprechende Steuerbefehle beeinflussen.

## Patentansprüche

1. Verfahren zur Feststellung der Beeinflussung der von einem Verbrauchsmengenzähler gemessenen Energieflüsse durch zumindest eine Steuereinrichtung, die zumindest einen in einem Versorgungsnetz betriebenen Teilnehmer steuert, und deren Zuordnung zueinander,
umfassend:
- Aussenden von Steuerbefehlen von der Steuereinrichtung an den zumindest einen Teilnehmer,
- Empfangen von Zählwerten des Verbrauchsmengenzählers in der Steuereinrichtung,
- zeitliches Korrelieren der empfangenen Zählwerte mit von den Steuerbefehlen abhängigen, in der Steuereinrichtung gespeicherten Erwartungswerten für die Zählwerte und
- Feststellen der Beeinflussung des Verbrauchsmengenzählers durch die Steuereinrichtung abhängig von der Korrelation und Zuordnung zueinander anhand der Beeinflussung.

2. Verfahren nach Anspruch 1,
**dadurch gekennzeichnet,**
- **dass** die empfangenen Zählwerte mit den Erwartungswerten fortlaufend korreliert werden und dass Zuordnungen dynamisch abhängig von aktuellen Korrelationen verändert werden.

3. Verfahren nach Anspruch 1 oder 2,
**dadurch gekennzeichnet,**
- **dass** die Erwartungswerte abhängig von Sendezeitpunkten der Steuerbefehle und/oder Informationen zu einer Leistung des Teilnehmers und/oder einem Betriebsverhalten des Teilnehmers sind.

4. Verfahren nach einem der vorangehenden Ansprüche,
**dadurch gekennzeichnet,**
- **dass** die Erwartungswerte eine zeitliche Reihe von Erwartungswerten umfassen und dass die Zählwerte eine zeitliche Reihe von Messwerten umfassen, insbesondere Energiemesswerte, Leistungsmesswerte, Strommesswerte und/oder Spannungsmesswerte.

5. Verfahren nach einem der vorangehenden Ansprüche,
**dadurch gekennzeichnet,**
- **dass** die Steuerbefehle Zu- und/oder Abschaltbefehle für den Teilnehmer umfassen und/oder dass die Steuerbefehle zumindest eine Leistungsvorgabe für den Teilnehmer umfassen.

6. Verfahren nach einem der vorangehenden Ansprüche,
**dadurch gekennzeichnet,**
- **dass** zumindest abhängig von der Zuordnung eine von der Steuereinrichtung an den Teilnehmern an jeweils einem Verbrauchsmengenzähler beeinflussbare Leistung bestimmt wird.

7. Verfahren nach einem der vorangehenden Ansprüche,
**dadurch gekennzeichnet,**
- **dass** zumindest ein Verbrauchsmengenzähler einem Verknüpfungspunkt zwischen einem Hausverteilnetz und einem öffentlichen Versorgungsnetz zugeordnet wird und dass der Steuereinrichtung abhängig von der Zuordnung eine an dem Verknüpfungspunkt beeinflussbare Leistung zugeordnet wird.

8. Verfahren nach einem der vorangehenden Ansprüche,
**dadurch gekennzeichnet,**
- **dass** die Steuereinrichtung einen Vorgabewert für eine Veränderung einer Leistung an einem Verknüpfungspunkt empfängt und abhängig von dem Vorgabewert zumindest einen Teilnehmer ansteuert.

9. Verfahren nach einem der vorangehenden Ansprüche,
**dadurch gekennzeichnet,**
- **dass** zumindest drei Steuereinrichtungen kaskadiert verschaltet sind, so dass zumindest eine erste, übergeordnete Steuereinrichtung zumindest zwei voneinander unabhängige nachgeordnete Steuereinrichtungen ansteuert und
**dass** die Zuordnung zu einer der nachgeordneten Steuereinrichtungen und zumindest einer der übergeordneten Steuereinrichtungen erfolgt.

10. Verfahren nach einem der vorangehenden Ansprüche,
**dadurch gekennzeichnet,**
- **dass** der Verbrauchsmengenzähler ein Energiemengenzähler, insbesondere ein elektrischer Energiemengenzähler, insbesondere ein Smart Meter oder ein intelligentes Messsystem ist.

11. Verfahren nach einem der vorangehenden Ansprüche,
**dadurch gekennzeichnet,**
- **dass** das Verbrauchsmengenzähler in Kommunikationsverbindung mit der Steuereinrichtung ist.

12. Verfahren nach einem der vorangehenden Ansprüche,
**dadurch gekennzeichnet,**
- **dass** zumindest ein Verbrauchsmengenzähler in einem Hausverteilnetz angeordnet ist und/oder dass zumindest ein Verbrauchsmengenzähler in einem öffentlichen Versorgungsnetz angeordnet ist.

13. Verfahren nach einem der vorangehenden Ansprüche,
**dadurch gekennzeichnet,**
- **dass** der Teilnehmer ein Verbraucher, insbesondere ein elektrischer Verbraucher ist und/oder dass der Teilnehmer ein Erzeuger, insbesondere ein elektrischer Erzeuger ist und/oder dass der Teilnehmer ein Speicher, insbesondere ein elektrischer Speicher ist.

14. Verfahren nach einem der vorangehenden Ansprüche,
**dadurch gekennzeichnet,**
- **dass** die Steuereinrichtung ein Energiemanagementsystem ist.

15. System eingerichtet zur Durchführung eines Verfahrens nach einem der vorangehenden Ansprüche mit einer Steuereinrichtung, zumindest einem Verbrauchsmengenzähler und einem Teilnehmer in einem Versorgungnetz, wobei die Steuereinrichtung in Wirkverbindung mit dem Teilnehmer ist und wobei der Verbrauchsmengenzähler in Kommunikationsverbindung mit der Steuereinrichtung ist.

## Claims

1. Method for determining the influence of at least one control device, which controls at least one subscriber operated in a supply network, on the energy flows measured by a meter, and their mapping to one another, comprising:
- sending control commands from the control device to the at least one subscriber,
- receiving count values from the meter in the control device,
- temporally correlating the received count values with expected values for the count values which are dependent on the control commands and are stored in the control device, and
- determining the influence on the meter by the control device depending on the correlation and mapping them to one another on the basis of the influence.

2. Method according to claim 1,
**characterized in that**
- the received count values are continuously correlated with the expected values and the mappings are dynamically changed depending on current correlations.

3. Method according to claim 1 or 2,
**characterized in that**
- the expected values are dependent on transmission times of the control commands and/or information on a power of the subscriber and/or an operating behavior of the subscriber.

4. Method according to one of the preceding claims,
**characterized in that**
- the expected values comprise a temporal series of expected values and **in that** the count values comprise a temporal series of measured values, in particular measured energy values, measured power values, measured current values and/or measured voltage values.

5. Method according to one of the preceding claims,
**characterized in that**
- the control commands comprise connection and/or disconnection commands for the subscriber and/or **in that** the control commands comprise at least one power specification for the subscriber.

6. Method according to one of the preceding claims,
**characterized in that**
- a power which can be influenced by the control device at the subscribers at a respective meter is determined at least as a function of the mapping.

7. Method according to one of the preceding claims,
**characterized in that**
- at least one meter is assigned to a connection point between a house distribution network and a public supply network, and **in that** the control device is assigned a power which can be influenced at the connection point as a function of the mapping.

8. Method according to one of the preceding claims,
**characterized in that**
- the control device receives a preset value for a change in a power at a connection point and controls at least one subscriber as a function of the preset value.

9. Method according to one of the preceding claims,
**characterized in that**
- at least three control devices are connected in cascade, so that at least one first, higher-level control device actuates at least two mutually independent lower-level control devices, and **in that** the mapping is done to one of the lower-level control devices and at least one of the higher-level control devices.

10. Method according to one of the preceding claims,
**characterized in that**
- the meter is an energy meter, in particular an electrical energy meter, in particular a smart meter or an intelligent metering system.

11. Method according to one of the preceding claims,
**characterized in that**
- the meter is in communication connection with the control device.

12. Method according to one of the preceding claims,
**characterized in that**
- at least one meter is arranged in a house distribution network and/or at least one meter is arranged in a public supply network.

13. Method according to one of the preceding claims,
**characterized in that**
- the subscriber is a consumer, in particular an electrical consumer, and/or **in that** the subscriber is a generator, in particular an electrical generator, and/or **in that** the subscriber is a storage device, in particular an electrical storage device.

14. Method according to one of the preceding claims,
**characterized in that**
- the control device is an energy management system.

15. System arranged for carrying out a method according to one of the preceding claims, comprising a control device, at least one meter and a subscriber in a supply network, wherein the control device is in operative connection with the subscriber and wherein the meter is in communication connection with the control device.

## Revendications

1. Procédé pour déterminer l'influence exercée par au moins un dispositif de commande, qui commande au moins un abonné exploité dans un réseau de distribution, sur les flux d'énergie mesurés par un compteur de consommation, et leur association mutuelle, comprenant :
- envoyer des instructions de commande par le dispositif de commande à l'au moins un abonné,
- recevoir des valeurs de comptage du compteur de consommation dans le dispositif de commande,
- mettre en corrélation temporelle des valeurs de comptage reçues avec des valeurs attendues pour les valeurs de comptage, dépendantes des instructions de commande et mémorisées dans le dispositif de commande, et
- déterminer de l'influence du compteur de consommation par le dispositif de commande en fonction de la corrélation et de l'association entre elles sur la base de l'influence.

2. Procédé selon la revendication 1,
**caractérisé en ce que**
- les valeurs de comptage reçues sont mises en corrélation en continu avec les valeurs attendues et que les associations sont modifiées de manière dynamique en fonction des corrélations actuelles.

3. Procédé selon la revendication 1 ou 2,
**caractérisé en ce que**
- les valeurs attendues dépendent des instants d'émission des instructions de commande et/ou d'informations relatives à une puissance de l'abonné et/ou à un comportement de fonctionnement de l'abonné.

4. Procédé selon l'une des revendications précédentes,
**caractérisé en ce que**
- les valeurs attendues comprennent une série temporelle de valeurs attendues et que les valeurs de comptage comprennent une série temporelle de valeurs mesurées, en particulier des valeurs de mesure d'énergie, des valeurs de mesure de puissance, des valeurs de mesure de courant et/ou des valeurs de mesure de tension.

5. Procédé selon l'une des revendications précédentes,
**caractérisé en ce que**
- les instructions de commande comprennent des instructions d'activation et/ou de désactivation pour l'abonné et/ou que les instructions de commande comprennent au moins une exigence de puissance pour l'abonné.

6. Procédé selon l'une des revendications précédentes,
**caractérisé en ce que**
- au moins en fonction de association, une puissance à un compteur de consommation respectif pouvant être influencée par le dispositif de commande aux abonnés est déterminée .

7. Procédé selon l'une des revendications précédentes,
**caractérisé en ce que**
- au moins un compteur de consommation est associé à un point de connexion entre un réseau de distribution domestique et un réseau de distribution public et qu'une puissance pouvant être influencée au niveau du point de connexion est associée au dispositif de commande en fonction de l'association.

8. Procédé selon l'une des revendications précédentes,
**caractérisé en ce que**
- le dispositif de commande reçoit une valeur d'exigence pour une modification d'une puissance à un point de connexion et commande au moins un abonné en fonction de la valeur d'exigence.

9. Procédé selon l'une des revendications précédentes,
**caractérisé en ce que,**
- au moins trois dispositifs de commande sont connectés en cascade, de sorte qu'au moins un premier dispositif de commande de niveau supérieur commande au moins deux dispositifs de commande de niveau inférieur indépendants l'un de l'autre, et que l'association se fait à un des dispositifs de commande de niveau inférieur et à au moins un des dispositifs de commande de niveau supérieur.

10. Procédé selon l'une des revendications précédentes,
**caractérisé en ce que**
- le compteur de consommation est un compteur d'énergie, en particulier un compteur d'énergie électrique, notamment un compteur intelligent ou un système de mesure intelligent.

11. Procédé selon l'une des revendications précédentes,
**caractérisé en ce que**
- le compteur de consommation est en liaison de communication avec le dispositif de commande.

12. Procédé selon l'une des revendications précédentes,
**caractérisé en ce que**
- au moins un compteur de consommation est disposé dans un réseau de distribution domestique et/ou qu'au moins un compteur de consommation est disposé dans un réseau de distribution public.

13. Procédé selon l'une des revendications précédentes,
**caractérisé en ce que**
- l'abonné est un consommateur, en particulier un consommateur électrique et/ou que l'abonné est un producteur, en particulier un producteur électrique et/ou que l'abonné est un accumulateur, en particulier un accumulateur électrique.

14. Procédé selon l'une des revendications précédentes,
**caractérisé en ce que**
- le dispositif de commande est un système de gestion de l'énergie.

15. Système configuré pour effectuer un procédé selon l'une des revendications précédentes, comprenant un dispositif de commande, au moins un compteur de consommation et un abonné dans un réseau de distribution, où le dispositif de commande est en liaison active avec l'abonné et le compteur de consommation est en liaison de communication avec le dispositif de commande.
